# EUROPEAN PATENT SPECIFICATION

(11) **EP 0 908 731 B1**
(45) Date of publication and mention of the grant of the patent: **30.05.2001**
(21) Application number: 97830516.7
(22) Date of filing: 10.10.1997
(51) Int. Cl.: G01R 13/32, G01R 31/26, G01J 1/42, G01D 3/02

(54) **Process for characterising a plurality of similar photocells and for the automatic control of a photocell**
Verfahren zur Charakterisierung einer Vielzahl gleichartiger Photozellen und zur automatischen Einstellung einer Photozelle
Procédé de caractérisation d'une multitude de cellules photoélectriques similaires et d'ajustement automatique d'une cellule photoélectrique

(43) Date of publication of application: 14.04.1999
(73) Proprietor: DATALOGIC S.P.A., 40012 Lippo di Calderara di Reno (Bologna) (IT)
(72) Inventor: Tamanti, Maria Lisa, 47020 Cesena (Forli) (IT); Righi, Gianfranco, 41100 Modena (IT)
(74) Representative: Checcacci, Giorgio

(56) References cited:
- EP-A- 0 618 555
- US-A- 5 266 792
- US-A- 5 276 389
- R. SCHIFFEL: "Grundschaltungen der Elektronik - Optokoppler Teil 2", FUNKSCHAU, Franzis Verlag, MUNICH, GERMANY, April 1985, vol. , no. 17, pages 51 to 53

## Description

The present invention relates to a process for the characterization of a plurality of photocells and also to a process for the automatic control of a photocell for which operating characteristic is known.

As it is known, a photocell is an optical device capable of transforming a variation of luminous intensity into a variation of electric signals (intensity of current and/or voltage) and vice versa.

Such devices are often used as means for detecting the presence or absence of a given object in a given position; in such case the photocell generally comprises a luminous source and a photo receiver element, placed in front of the luminous source or nearby it, and used to collect the luminous signal issued from the luminous source and to generate an electric output signal, as function of the collected luminous signal.

The eventual presence of an object interposed in the optical path between the luminous source and the photo receiver element is detected through the variation of intensity of the luminous signal collected and, consequently, through the variation of intensity of the electric signal generated from the photo receiver element.

Typically, solid state devices, generally indicated by the technical term LED, are used as luminous sources. These devices are electro-optical devices in which the luminous signal issued is a function of the supply current generated by an appropriate supply circuit.

A disadvantage associated with the LED, especially those of low cost, is related to the fact that they present a high dispersal of some fundamental operating parameters, such as for example luminous efficiency and voltage drop on the same LED. It occurs in fact that equal LED (hereon in, the terminology equal LED or photocell is used to indicate LED or photocell acquired from the same maker and having the same product initials) show, at equal temperature and supply current, very different luminous efficiency and voltage drop values. Similarly, equal photo receivers present a dispersal of reception sensitivity of the luminous signal (photo receiver gain).

Luminous efficiency of a LED is used to mean the ratio between the luminous intensity of the light actually issued and that theoretically expected, for a certain supply current. Similarly, reception sensitivity (or gain) of a photo receiver, is used to mean the ratio between the actual voltage generated from the photo receiver and that theorycally expected, for a certain luminous intensity received.

Since the exceeding or not exceeding of the commutation threshold (that is the limit value of the electric output signal below which the presence of an object will not be detected) depends on the luminous efficiency of the LED and on the photo receiver gain, it happens that equal photocells, in the same operating conditions, as a result of the dispersal of the characteristics of the single LED and/or photocells having the same commercial initials (that is belonging to the same technological family), will perform differently in the presence of the same object placed between the LED and the photo receiver, that is it may happen that some photocells would detect the presence of the object while other ones would not.

To overcome said disadvantage, all photocells present a control element which, at the production step or in the initial setting, is controlled in such a way to vary the intensity of the current which circulates in the emission LED or the sensitivity of the photo receiver, in this way compensating for the different luminous efficiencies of the LED and in order to have, in a given situation; a constant electric output signal for all equal photocells.

Another disadvantage associated with the photocell is related to the thermal drift of the emission LED and of the photo receiver. It has occurred in fact that, by increasing the environmental temperature, the luminous efficiency of the LED decreases while the sensitivity of the photo receiver increases. This involves a variation over time of the electric output signal and therefore an incorrect functioning of the photocell during the operation.

In the following of the present description, correct functioning of a photocell shall be intended to be that said functioning for which the photocell generates, in varying the temperature, a value of the electric output signal substantially constant over time.

Methods for compensating the variation in temperature, in order to maintain the electric output signal within a preset interval of values, thereby guaranteeing at the time a correct operation of the photocell, provide the use of temperature compensation devices within feedback circuits and capable of varying at the right moment the supply current of the LED, or the photo receiver gain, function of the variation of temperature.

A disadvantage with such compensation circuits is related to the fact that these are designed for a single LED and for a specific supply current value. In operation, instead, the actual current which circulates in the LED may be different from that for which the thermal compensation was programmed, therefore decreasing, or even cancelling, the efficiency of said compensation.

Another disadvantage associated with the photocells is related to the LED and the photo receiver ageing , which causes a decrease in the luminous efficiency of the former and in the sensitivity of the latter; as already mentioned, this brings about an incorrect operation of the photocell.

Funkschau, nr. 17, April 1985; Franzis Verlag, Munich, Germany, pages 51 to 53, R Schiffel: "Grundschaltungen der Elektronik-Optokoppler Teil 2" discloses an optical coupler comprising an emission LED designed for being supplied with a supply current and a photo receiver designed to collect the luminous signal issued from the emission LED and to generate an electric output signal function of the collected luminous signal. The coupling factor of the optical coupler is related with respect to the supply current of the LED for different values of the temperature. It is stated that it is not necessary to carry out any thermal compensation of the optical coupler since it is self-compensated, because the temperatures coefficient of the LED and of the photoreceiver are mutually opposed.

US 5,276,389 discloses a method of controlling a vehicular windshield wiper system according to a plurality of operating thresholds established to ensure smooth operation of the wiping system during varying conditions and according to an amplification autoranging strategy to ensure the wiping system functions properly independent of certain conditions, such us the type of windshield on the vehicle. The wiping system includes a photocell provided with a sensor for monitoring a portion of the windshield and generating a signal having a value which varies as both moisture and dirt collect on the monitored portion.

The technical problem at the base of the present invention is that of providing a process of contained cost which allows, through simple and quick operations, the correct functioning of equal photocells over time.

The invention is based on the perception that different LED belonging to the same technological family (though having basic luminous efficiency even very different among them) present a variation of luminous efficiency depending on the temperature having a substantially equal trend.

The invention concerns therefore, in a first aspect, a process for the characterization of a plurality of photocells by means of an apparatus comprising a climatic room, said plurality of photocells including emission LEDs emitting a luminous signal and photo receiver elements, wherein at least the LEDs or the photo receivers belong to the same technological family and at least one element among the emission LED and the photo receiver element of a photocell of said plurality of photocells is placed in the climatic room,
the process comprising the following steps:
- feeding the emission LED of said photocell with a supply current of a predetermined value Iled,
- regulating the temperature of the climatic room at a test temperature of a predetermined value T,
- collecting the luminous signal issued from the emission LED into the photo receiver element of said photocell and generating an electric output signal in response to the collected luminous signal,
- measuring the value of the electric output signal Vout,
- storing the set of the three values (Iled, T, Vout),
- repeating the previous steps for a prefixed number i of times, each time varying the values of two of the three variables supply current, electric output signal and test temperature in order to store a number of set of three values (Iled, T, Vout) thereby to obtain a relationship between supply current, electric output signal and temperature to characterize said photocell,
- using said stored sets of the three values (Iled, T, Vout) for characterizing all the other photocells of said plurality of photocells.

In the following of the present description and in the subsequent claims, "climatic room" shall be intended to mean an environment in which it is possible to measure the temperature and to modify it. Such an environment may therefore be a well-defined closed space, completely isolated from the external environment and equipped with more or less sophisticated regulatory and control instrumentation.

Through a unique data extraction process comprising the above-mentioned steps, it is possible to obtain by way of experimentation a mathematical relationship among Iled, T and Vout for all the equal photocells belonging to a given technological family. It has in fact been demonstrated through experiments how the LED luminous efficiency (and/or the sensitivity of the photo receivers) variation, in varying the temperature, becomes an exclusive function of the supply current and that such variation results in being the same for LED (and/or photo receivers) belonging to the same technological family. Knowing the mathematical relationship between Iled, T and Vout allows therefore the characterization, with a single experimental test, of all the photocells having the same commercial initials in this way guaranteeing, through the use of appropriate control process based on the variation of the supply current, the correct operation of the photocell based on the specific operative conditions of the application.

Preferably, the above-mentioned process advantageously comprises the following steps:
a) selecting a value Voutⱼ of the electric output signal,
b) regulating the temperature of the climatic room at a test temperature Tᵢ,
c) feeding the emission LED with an initial supply current Iledᵢⱼ such that the value of the electric output signal is equal to the selected value Voutⱼ of the electric output signal,
d) storing the set of the two values of the temperature Tᵢ and of the initial supply current Iledᵢⱼ,
e) iteratively repeating, for a prefixed number i of times, the steps from b) to d) for different values of the temperature Tᵢ and of the supply current Iledᵢⱼ, in this way constructing a characterization curve relative to the value Voutⱼ of the electric output signal,
f) iteratively repeating the previous steps for a prefixed number j of times and for different j values of the electric output signal Vout, in this way constructing j characterization curves relative to the j values of the electric output signal Vout.

In this way it is possible to represent (graphically or through tables or the like) the trend of the supply current Iled in varying the environmental temperature T, for different constant values of the electric output signals Vout. This allows one to have a clear and thorough picture relative to the characteristic of optimum functioning of the photocell whatever the thermal environmental conditions in operation and whatever the specific application for which the photocell is predisposed. Such a picture allows an efficient control of the same photocell. This representation with constant Vout seems to be the more suitable to the usual applications of a photocell, in which Vout is a pre-defined design value .

Alternatively, representations are possible with constant Iled or T. For example, the aforesaid process may comprise the following steps:
a) feeding the emission LED with an initial supply current Iledⱼ,
b) regulating the temperature of the climatic room at a test temperature Tᵢ,
c) measuring the value Voutᵢⱼ of the electric output signal,
d) storing the set of the two values of the test temperature Tᵢ and of the electric output signal Voutᵢⱼ,
e) iteratively repeating, for a prefixed number i of times, the steps from b) to d) for different values Tᵢ of the temperature, in this way constructing a characterization curve relative to the value Iledⱼ of the supply current,
f) iteratively repeating the previous steps for a prefixed number j of times and for different j values of the supply current Iled, in this way constructing j characterization curves relative to the j values of the supply current Iled.

In this way it is possible to represent (graphically or through tables or the like) the trend of the electric output signal Vout in varying the environmental temperature T, for different values of the supply current Iled. In this way a series of curves are obtained which, similarly to those previously cited, allow an efficient control of the photocell.

Again, the aforesaid process comprise the following steps:
a) regulating the temperature of the climatic room at a test temperature Tⱼ,
b) feeding the emission LED with an initial supply current Iled₁,
c) measuring the value Voutᵢⱼ of the electric output signal,
d) storing the set of the two values of the supply current Iledᵢ and of the electric output signal Voutᵢⱼ,
e) iteratively repeating, for a prefixed number i of times, steps b) to d) for different values of the supply current Iledᵢ, in this way constructing a characterization curve relative to value Tⱼ of the temperature,
f) iteratively repeating the previous steps for a prefixed number j- of times and for different j values of the temperature T, in this way constructing j characterization curves relative to the j values of the temperature T.

In this way it is possible to graphically represent the trend of the supply current Iled in varying the electric output signal Vout, for different values of environmental temperature T. A series of curves are obtained which, similarly to those cited above, allow an efficient control of the photocell.

Through the process described above, the characterization of the whole photocell is possible, understood as LED and photo receiver on the whole, or as single photo elements of the photocell.

In the case in which one wishes to characterize the whole photocell, the emission LED and the photo receiver element are both positioned within the climatic room.

In the case where one wishes to characterize the emission LED only, the photo receiver element is positioned outside the climatic room and the luminous signal is collected from said element by an optical fibre positioned between the emission LED and the photo receiver element.

Similarly, in the case where one wishes to characterize the photo receiver element only, the emission LED is positioned outside the climatic room and the luminous signal is carried to the photo receiver element through an optical fibre positioned between the emission LED and the same photo receiver element.

In a second aspect, the present invention concerns a process for the automatic control of a photocell, said photocell comprising:
- an emission LED emitting a luminous signal, said LED being fed with a supply current Iled,
- a photo receiver element designed to collect the luminous signal issued from the emission LED and to generate an electric output signal Vout in response to the collected luminous signal,
of said photocell being known a relationship between the supply current Iled, the electric output signal Vout and the environmental temperature T,
the process comprising the following operating steps:
a) activating an initial acquisition process in order to control the photocell at an optimum value of the electric output signal Vout chosen in function of the specific application of the photocell,
b) carrying out a thermal compensation of the photocell based on the relationship between the supply current Iled, the electric output signal Vout and the temperature T, by varying the supply current Iled according to the variations of the temperature T at which the photocells operates, in order to maintain during operation a value of the electric output signal Vout substantially equal to the optimum value chosen in the initial acquisition process,
characterised in that the initial acquisition process comprises the following steps:
a1) choosing, based on the specific application of the photocell, an optimum value of the electric output signal Vout,
a2) measuring the temperature value T at which the photocell operates,
a3) storing said set of the two values of the electric output signal Vout and temperature T and identifying from previously stored sets of three characterization values (Iled, T, Vout) of the supply current, the electric output signal and the environmental temperature, an optimum supply current Iled such that the value of the electric output signal Vout is substantially equal to the optimum value chosen in the initial acquisition process.

Such a process allows not only to carry out a thermal compensation "adapted" to the supply current that circulates in the emission LED (thanks to the knowledge of the relationship between the Iled, the Vout and the temperature T) overcoming in this way the disadvantages of the prior art and guaranteeing a correct operation of the photocell, but also to optimize, through the initial acquisition process , the operation of the same photocell in function of the specific operating conditions (for example: dimensions, distance and reflectivity of the object to be recognized, the state of ageing of the emission LED and of the photo receiver element etc...).

Preferably, the identification of the optimum supply current Iled of step a3) is carried out by identifying in a graph relating the temperature (T) and the supply current (Iled) a characterization curve of the photocell such that the value of the electric output signal Vout is substantially equal to the optimum value chosen in the initial acquisition process.

Such an acquisition process allows therefore to determine, automatically and in a relatively short time, the optimum supply current which should circulate in the emission LED so that the photocell, in those particular operating conditions, may recognise a particular object. Once this process is concluded, the photocell is operative.

The information of the temperature stored in the initial acquisition process allows further to identify in a unique way the specific characterization curve for that particular application; the subsequent thermal compensation, in operation, would then occur following such curve, until a new acquisition process will start.

Such a situation is verified for example when, other conditions being equal, one wishes to recognise a different object from the previous one, or when one wishes to reset the photocell following a variation of luminous efficiency of the emission LED or gain of the photo receiver caused by uncleanness or ageing of said optical components.

In such situations, a new optimum condition for the operation of the photocell would be identified, represented on the characterization curve graph by a new operating point. The optimum supply current would probably be different from the previous one and the subsequent thermal compensation would follow a different characterization curve from the previous one. One would obtain therefore, differently from the prior art, a thermal compensation "adapted" to the optimum supply current.

Preferably, the step of thermal compensation of the photocell comprises the following steps:
- b1) detecting a variation of the temperature at which the photocell operates,
- b2) varying the supply current Iled according to the characterization curve identified in step a4) so that the value of the electric output signal Vout remains substantially equal to the chosen optimum value in the initial acquisition process.

Differently from the prior art, in which the thermal compensation occurs following a unique curve, the thermal compensation in accordance with the present invention results in being "adapted" to the initial supply current which circulates in the emission LED and under the specific operating conditions in which the photocell operates. It is therefore possible to choose the most appropriate characterization curve in varying said operating conditions.

In a third aspect, the present invention concerns a photocell apparatus in which it is possible to carry out an automatic control following the above process, the apparatus comprising:
- an emission LED emitting a luminous signal, said LED being fed with a supply current Iled,
- a photo receiver element designed to collect the luminous signal issued from the emission LED and to generate an electric output signal Vout proportionate to the luminous signal,
- amplifying means for amplifying the electric output signal Vout,
- a processing unit for determining the optimum current Iled,
- a temperature sensor connected to the processing unit,
characterised in that the processing unit for determining the optimum current Iled is adapted to carry out an initial acquisition step and a thermal compensation step as claimed in claim 8.

A photocell apparatus of such type is capable of automatically managing the control of the photocell. In fact, in the processing unit, all of the data relative to the characterization of the photocell which one wishes to use, are stored, in this way allowing an initial acquisition and thermal compensation process adapted to the specific operating conditions for the use of the photocell.

Further characteristics and advantages of a characterization and automatic control process of a photocell according to the present invention, will appear more clearly from the following description of some preferred embodiments, made with reference to the attached drawings. In said drawings,
- figure 1 schematically shows a photocell able to carry out the process of automatic control of the present invention,
- figure 2 schematically shows an apparatus able to carry out a first embodiment of the process for the characterization of the photocell,
- figure 3 shows a graphic representation of a family of characterization curves obtained by the apparatus in figure 2,
- figure 4 shows the use of the apparatus in figure 2 in a second embodiment of the process for the characterization of the photocell,
- figure 5 shows the use of the apparatus of figure 2 in a third embodiment of the process for the characterization of the photocell,
- figure 6 schematically shows an example of construction of a first series of characterization curves of figure 2,
- figure 7 schematically shows an example of construction of a second series of characterization curves of figure 3,
- figure 8 schematically shows an example of construction of a third series of characterization curves of figure 3.

In such figures, 1 represents a photocell able to carry out an automatic control of temperature.

The photocell 1 comprises an emission part 2, for the emission of a luminous signal 3, and a receiver part 4, designed to collect the luminous signal 3 issued from the emission part 2.

The emission part 2 comprises an emission LED 5 (for example one of those cited in the data sheet LH T674 of 10.95 provided from Siemens) fed by a supply current Iled generated from an appropriate electric feed circuit connected to a data processing unit 10.

The receiver part 4 comprises photo diode reception 7 producing, by an appropriate electric reception circuit connected to an amplifying unit 9, an electric output signal Vout (typically a tension).

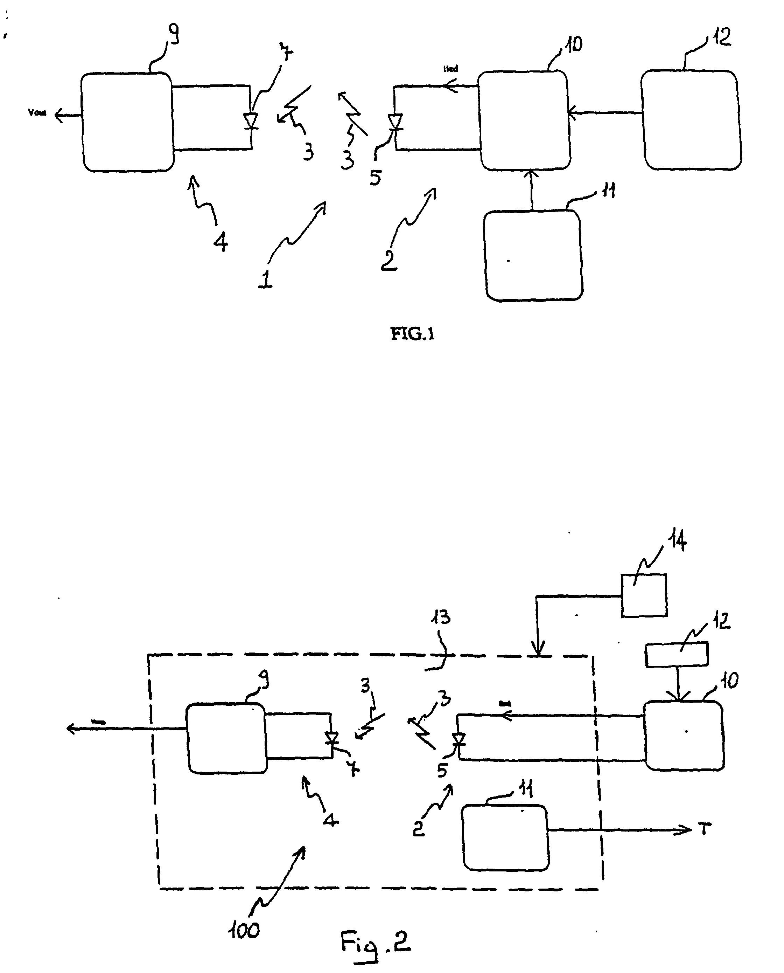

In the following description, reference shall be made, as a general but not limited example, to the embodiment of the photocell 1 represented in figures 1, 2, 4 and 5, in which the emission LED 5 and the photo diode reception 7 are placed, one in front of the other, at opposite sides with respect to a possible object to be "recognized", in order to define, among these, an optical path which is substantially straight. However, what has been said results similarly true and of immediate application even for different embodiments of the photocell 1, for example those in which the emission LED 5 and the photo diode reception 7 are positioned, the one beside the other, on the same part with respect to a possible object to be "recognized".

The data processing unit 10 connected to the feed circuit of the emission LED 5 is capable of controlling the supply current Iled circulating inside. The processing unit 10 also stores the data obtained from tests of characterization of the photocell and, by the aid of a temperature sensor 11 connected within and by external driving means 12, it manages an initial acquisition and thermal compensation procedure of the same photocell.

The photocell 1 may be inserted inside an apparatus 100 capable of obtaining characterization curves of the same photocell 1. In such a case, as shown in figure 2, the whole photocell 1, that is both the emission LED 5 and the photo receiver element 7, is mounted inside a climatic room 13 equipped with control means 14 of the temperature of the same room.

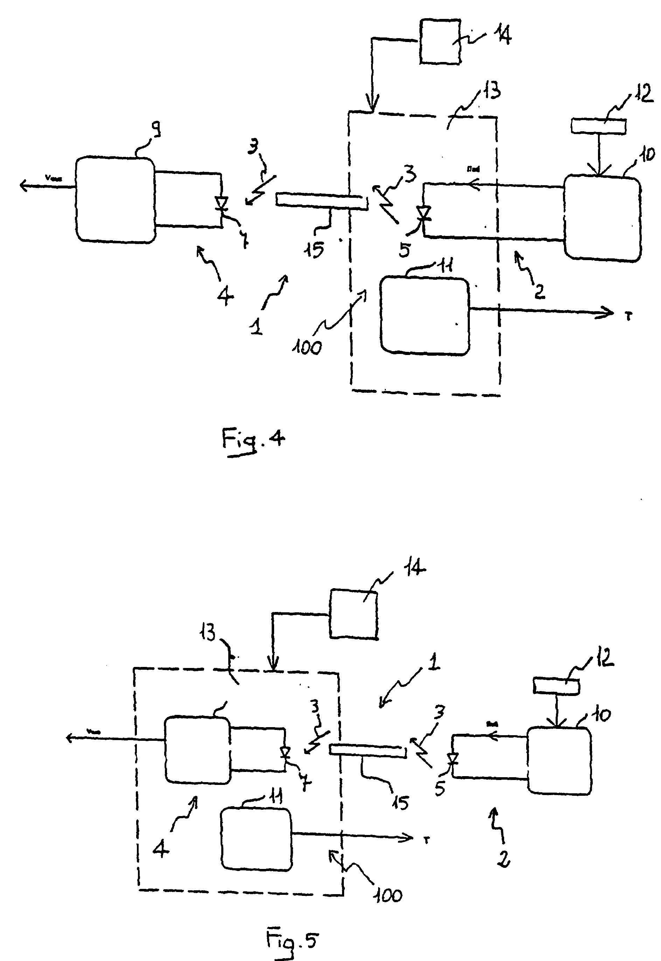

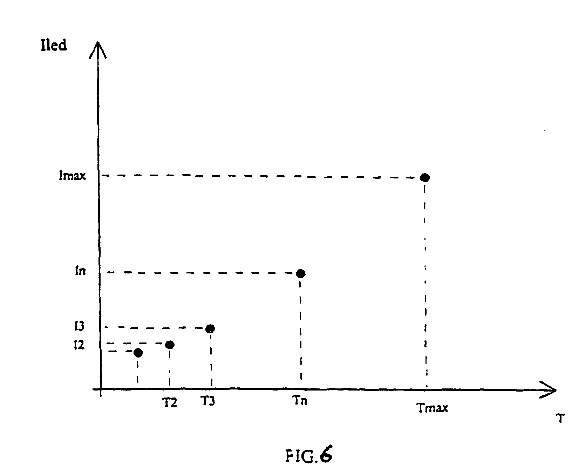

It is also possible, by the apparatus 100, to characterize even the emission LED 5 alone or the photo receiver element 7 alone of the photocell 1. In the first case, as shown in figure 4, the photo receiver element 7 is positioned outside the climatic room 13 and the luminous signal 3 is collected from said element 7 through an optical fibre 15 placed between the emission LED 5 and the photo receiver element 7. In the second case, as shown in figure 5, the emission LED is placed outside the climatic room 13 and the luminous signal 3 is carried to the photo receiver 7 through the optical fibre 15 placed between the emission LED 5 and the photo receiver element 7.

By the characterization tests, which process will be described in detail below, the apparatus 100, as described above, allows for the acquisition of a series of useful data for the carrying out of the initial acquisition and thermal compensation procedure initial acquisition and thermal compensation, both actions guaranteeing a correct operation of the photocell.

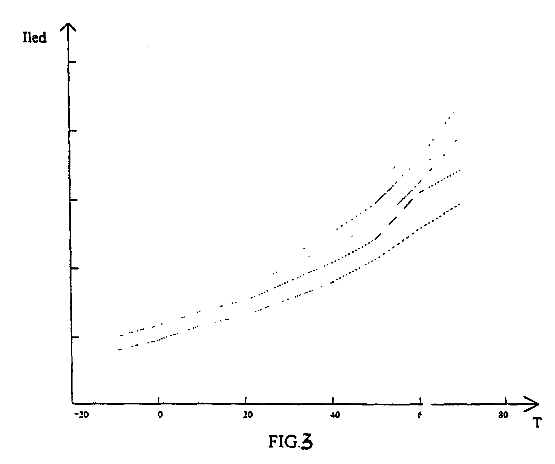

Through such data it is possible in fact to know the relationship between the supply current Iled, the electric output signal Vout and the temperature T at which the photocell 1 operates. Such relationship may be graphically represented in the form of characterization curves, as shown in figure 3, or in the form of data tables, or even in the form of mathematical function.

A detailed description of an embodiment of the process for the characterization of a photocell through the use of an apparatus 100 is given now, with particular reference to the test configuration of figure 2.

As mentioned before, the aim of such a process is to obtain a series of data clarifying the relationship among the supply current Iled, the electric output signal Vout and the temperature T at which the photocell 1 operates.

To reach this aim, a set formed by the emission LED 5 and the photo receiver element 7 which one wishes to characterize is placed inside the climatic room 13.

The process for characterizing said set of elements may be carried out in various ways all suitable to produce the wanted series of data.

For example, in a first particularly advantageous embodiment, it is supposed that one wishes to characterize the LED 5 - photo receiver 7 set in a thermal range that goes from Tmin to Tmax with a supply current Iled that can vary from Imin to Imax.

The thermal range is subdivided in n steps (Tmin, T2, ..Tn, ..Tmax) and the current range in m steps (Imin, I2,..Im,..Imax) and for every current step an experimental curve as illustrated in figure 6 is constructed as follows:
a) regulating, through appropriate control means (known and not illustrated), the supply current Iled in order to reach an initial value Imin;
b) choosing an initial test temperature Ti (for example Ti=Tmin) and, through the control means 14 of the temperature of the climatic room 13, such latter temperature is brought to Ti;
c) measuring the value of the electric output signal Vout;
d) storing the values of Iled, T and Vout;
e) varying, through the control means 14, the temperature of the climatic room 13 of one step in order to reach a temperature value of T2;
f) regulating the supply current Iled in order to reach a new value I2 so that the value of the measured electric output signal Vout is equal to the previous one;
g) reporting in a graph or a table (or anyway storing the data) the new value I2 of the Iled corresponding to the considered temperature step T2;
h) repeating the previous steps for everyone of the n temperature steps in order to obtain a curve corresponding to a particular value of the electric output signal Vout;
i) repeating the previous steps for everyone of the m current steps, in this way obtaining a plurality of curves, each one corresponding to a particular value of the electric output signal Vout.

The data obtained by the embodiment described above may be graphically represented on a Cartesian plane (T, Iled)by a plurality of curves with constant parameter Vout, as shown in figure 3.

As already mentioned, it is possible to characterize the LED 5 - photo receiver 7 set through alternative embodiments of the same characterization process. In a second embodiment, the process of characterization of the present invention foresees the following steps:
a) feeding the emission LED 5 with an initial supply current Iledⱼ;
b) regulating through the means 14, the temperature of the climatic room 13 at a test temperature Tᵢ;
c) measuring the value Voutᵢⱼ of the electric output signal;
d) storing the set of two values Tᵢ and Voutᵢⱼ in the processing unit 10;
e) iteratively repeating the steps from b) to d) , for a prefixed number i of times, for different values of Tᵢ, in this way constructing a characterization curve relative to the Iledⱼ value;
f) iteratively repeating the previous steps for a prefixed j number of times and for different j values of Iled, in this way constructing j characterization curves relative to the j values of Iled.

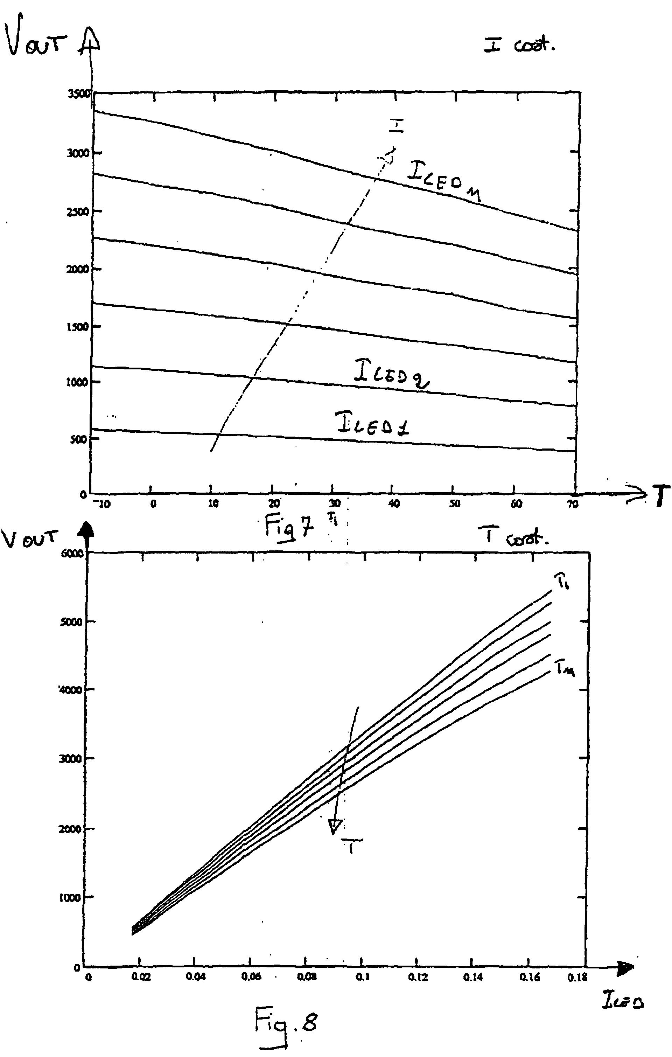

The data obtained through the embodiment described above, may be graphically represented on a Cartesian plane (T, Vout)with a plurality of curves of constant parameter Iled, as shown in figure 7.

In a third embodiment, the process of characterization of the present invention foresees the following steps:
a) regulating the temperature of the climatic room 13 at a test temperature of Tⱼ;
b) feeding the emission LED 5 with an initial supply current Iledᵢ;
c) measuring the value Voutᵢⱼ of the electric output signal;
d) storing the set of two values Iledᵢ and Voutᵢⱼ in the processing unit 10;
e) iteratively repeating steps from b) to d) for a prefixed number i of times, for different Iledᵢ values, so as to construct a characterization curve relative to the Tⱼ value;
f) iteratively repeating the previous steps for a prefixed j number of times and for different j values of T, so as to construct j characterization curves relative to the j values of T.

The data obtained through the embodiment described above, may be graphically represented on a Cartesian plane (Iled, Vout)with a plurality of curves of constant parameter T, as shown in figure 8.

By carrying out a linearization of the curve in figure 3 (or of the similar curve cited above) the subsequent stage of reduction in tables of data and of storing of the same data in the processing unit 10 is facilitated. Linearization allows in fact a drastic reduction of data to be stored, since every straight line is univocally identified by an angular coefficient and a known term. If one uses a processing unit 10 capable of storing and managing tables of more complex data it is possible to have better precision in the subsequent thermal compensation, storing curves more complex and in greater number. Also, through more or less complex mathematical calculations according to the degree of precision required, the processing unit 10 is capable of reconstructing even the curves not directly obtained from the data acquisition process.

In any case, the knowledge of the existing relationship between Iled, T and Vout allows then, in operation, the possibility to carry out an automatic control of the photocell 1 in order to optimize its operation according to the specific operating conditions.

The process for the automatic control of the photocell 1 is now described in detail.

At the time of installation, the user positions the object that needs to be "recognized" in front of the emission LED 5 and, acting on the external driving means 12 (essentially meaning one or more ON/OFF switches) starts an initial acquisition process managed by the processing unit 10. During such a process, which at most lasts some ten seconds, the processing unit 10, in which the data acquired from previous characterization tests are stored, regulates the photocell 1 at an optimum value of the electric output signal Vout chosen as a function of the specific operating conditions of the same photocell. The choice of the optimum value of the electric output signal Vout is a function, for example, of the dimensions, of the distance and the reflectivity of the object to be recognized, of the state of ageing of the emission LED 5 and of the photo receiver element etc...

Once the optimum value of the electric output signal Vout has been established, the processing unit 10 detects, by the sensor 11, which is the temperature T of the environment in which the photocell 1 operates and identifies, based on said values of Vout and T, the value of the optimum supply current Iled which should circulate in the emission LED 5 so that the object may be "recognized" with certainty.

It is clear that in this way, being equal the object to be seen and thermal conditions, the processing unit 10 will choose a higher Iled current in the photocell which holds LED 5 with minor luminous efficiency and a lower supply current Iled in the photocell which holds LED 5 with higher luminous efficiency. In this way the photocell 1 becomes independent from the different luminous efficiencies of the mounted LED 5 and from the different sensitivities of the photo receiver elements 7.

Once this initial process is concluded, the photocell 1 is operative and is capable of automatically compensating the thermal variations of the environment in which the photocell operates.

The temperature information stored in the initial acquisition process allows in fact the identification in a unique way of the specific characterization curve (among the many available, for example Vout₁) for that particular application; the subsequent thermal compensation, in operation, would occur following such curve.

It is assumed in fact that during the operation of the photocell 1 the thermal operating conditions would vary. The processing unit 10 detects, by the temperature sensor 11, the variation of temperature and varies the supply current Iled in the feed circuit so as to maintain substantially constant the optimum value of the electric output signal Vout chosen in the initial acquisition process.

Until a new acquisition process is not started, the thermal compensation would always follow the same curve (Vout₁) corresponding to said optimum value of the electric output signal Vout.

It may happen that there is a requirement for providing a new acquisition procedure . Such a situation occurs when for example, other conditions being equal, one wishes to "recognize" a different object from the previous one, or when one wishes to reset the photocell 1 following a variation of luminous efficiency from the emission LED 5 or from the sensitivity of the photo receiver 7 caused by the uncleanness or the ageing of the components.

In these situations, the new process is started simply by pressing the control key of means 12. The processing unit 10 identifies then a new optimum condition of operation of the photocell 1, represented on the characterization curve graph by a new operating point probably belonging to a new curve. The optimum supply current would in fact probably be different from the previous one and the subsequent thermal compensation would follow a characterization curve different from the previous one (for example Vout₂ on figure 3).

The present invention, as described above, allows the achievement of various advantages with respect to the prior art, among others those listed below:
- the possibility to experimentally characterize all the same photocells, belonging to the equal technological family, by a unique process of data extraction, with consequent reduction in time and cost relative to the carrying out of such experimental tests;
- the possibility for the user to select in a very simple and immediate way the modality of optimum operation for the different operating conditions, so as to always guarantee a correct operation of the photocell;
- the possibility for the user to select a new modality of operation which compensates the loss of luminous efficiency of the LED (or of the sensitivity of the photo receiver element) caused by ageing;
- the possibility to carry out a thermal compensation "adapted" to the specific operating conditions of the photocell;
- the possibility to characterize the single optical elements of the photocell.

## Claims

1. A process for the characterization of a plurality of photocells by means of an apparatus comprising a climatic room (13), said plurality of photocells including emission LEDs (5) emitting a luminous signal (3) and photo receiver elements (7), wherein at least the LEDs (5) or the photo receiver elements (7) belong to the same technological family and at least one element among the emission LED (5) and the photo receiver element (7) of a photocell of said plurality of photocells is placed in the climatic room (13), the process comprising the following steps:
- feeding the emission LED (5) of said photocell with a supply current of a predetermined value (Iled),
- regulating the temperature of the climatic room (13) at a test temperature of a predetermined value (T),
- collecting the luminous signal (3) issued from the emission LED (5) into the photo receiver element (7) of said photocell and generating an electric output signal in response to the collected luminous signal (3),
- measuring the value of the electric output signal (Vout),
- storing the set of the three values (Iled, T, Vout),
- repeating the previous steps for a prefixed number i of times, each time varying the values of two of the three variables supply current, electric output signal and test temperature in order to store a number of sets of three values (Iled, T, Vout), thereby to obtain a relationship between supply current, electric output signal and temperature to characterize said photocell,
- using said stored sets of the three values (Iled, T, Vout) for characterizing all the other photocells of said plurality of photocells.

2. Process as claimed in claim 1, comprising the following steps:
a) selecting a value (Voutⱼ) of the electric output signal,
b) regulating the temperature of the climatic room (13) at a test temperature (Tᵢ),
c) feeding the emission LED (5) with an initial supply current (Iledᵢⱼ) such that the value of the electric output signal is equal to the selected value (Voutⱼ) of the electric output signal,
d) storing the set of the two values of the temperature (Tᵢ) and of the initial supply current (Iledᵢⱼ),
e) iteratively repeating, for a prefixed number i of times, the steps from b) to d) for different values of the temperature (Tᵢ) and of the supply current (Iledᵢⱼ), in this way constructing a characterization curve relative to the value (Voutⱼ) of the electric output signal,
f) iteratively repeating the previous steps for a prefixed number j of times and for j different values of the electric output signal (Vout), in this way constructing j characterization curves relative to the j values of the electric output signal (Vout).

3. Process as claimed in claim 1, comprising the following steps:
a) feeding the emission LED (5) with an initial supply current (Iledⱼ),
b) regulating the temperature of the climatic room (13) at a test temperature (Tᵢ),
c) measuring the value (Voutᵢⱼ) of the electric output signal,
d) storing the set of the two values of the test temperature (Tᵢ) and of the electric output signal (Voutᵢⱼ),
e) iteratively repeating, for a prefixed number i of times, the steps from b) to d) for different values (Tᵢ) of the temperature, in this way constructing a characterization curve relative to the value (Iledⱼ) of the supply current,
f) iteratively repeating the previous steps for a prefixed number j of times and for j different values of the supply current (Iled), in this way constructing j characterization curves relative to the j values of the supply current (Iled).

4. Process as claimed in claim 1, comprising the following steps:
a) regulating the temperature of the climatic room (13) at a test temperature (Tⱼ),
b) feeding the emission LED (5) with an initial supply current (Iledᵢ),
c) measuring the value (Voutᵢⱼ) of the electric output signal,
d) storing the set of the two values of the supply current (Iledᵢ) and of the electric output signal (Voutᵢⱼ),
e) iteratively repeating, for a prefixed number i of times, steps b) to d) for different values of the supply current (Iledᵢ), in this way constructing a characterization curve relative to value (Tⱼ) of the temperature,
f) iteratively repeating the previous steps for a prefixed number j of times and for j different values of the temperature (T), in this way constructing j characterization curves relative to the j values of the temperature (T).

5. Process as claimed in claims 1, 2, 3, or 4, wherein the photo receiver element (7) is positioned outside the climatic room (13) and the luminous signal (3) is collected from said element (7) through an optical fibre (15) placed between the emission LED (5) and the photo receiver element (7).

6. Process as claimed in claims 1, 2, 3, or 4, wherein the emission LED (5) is positioned outside the climatic room (13) and the luminous signal (3) is carried to the photo receiver element (7) through an optical fibre (15) placed between the emission LED (5) and the photo receiver element (7).

7. Process as claimed in claims 1, 2, 3, or 4, wherein the emission LED (5) and the photo receiver element (7) are both positioned within the climatic room (13).

8. Process for the automatic control of a photocell, said photocell comprising:
- an emission LED (5) emitting a luminous signal (3), said LED (5) being fed with a supply current (Iled),
- a photo receiver element (7) designed to collect the luminous signal (3) issued from the emission LED (5) and to generate an electric output signal (Vout) in response to the collected luminous signal (3),
of said photocell being known a relationship between the supply current (Iled), the electric output signal (Vout) and the environmental temperature (T),
the process comprising the following operating steps:
a) activating an initial acquisition process in order to control the photocell at an optimum value of the electric output signal (Vout) chosen in function of the specific application of the photocell,
b) carrying out a thermal compensation of the photocell based on the relationship between the supply current (Iled), the electric output signal (Vout) and the temperature (T), by varying the supply current (Iled) according to the variations of the temperature (T) at which the photocells operates, in order to maintain during operation a value of the electric output signal (Vout) substantially equal to the optimum value chosen in the initial acquisition process,
characterised in that the initial acquisition process comprises the following steps:
a1) choosing, based on the specific application of the photocell, an optimum value of the electric output signal (Vout),
a2) measuring the temperature value (T) at which the photocell operates,
a3) storing said set of the two values of the electric output signal (Vout) and temperature (T) and identifying from previuosly stored sets of three characterization values (Iled, T, Vout) of the supply current, the electric output signal and the environmental temperature, an optimum supply current (Iled) such that the value of the electric
output signal (Vout) is substantially equal to the optimum value chosen the initial acquisition process.

9. Process as claimed in claim 8, wherein the identification of the optimum supply current (Iled) of step a3) is carried out by identifying in a graph relating the temperature (T) and the supply current (Iled) a characterization curve of the photocell such that the value of the electric output signal (Vout) is substantially equal to the optimum value chosen in the initial acquisition process.

10. Process as claimed in claim 9, in which the step of thermal compensation of the photocell comprises the following steps:
b1) detecting a variation of the temperature at which the photocell operates,
b2) varying the supply current (Iled) in accordance with the characterization curve identified in step a3) so that the electric output signal (Vout) is maintained substantially equal to the optimum value chosen in the initial acquisition process.

11. A photocell comprising:
- an emission LED (5) emitting a luminous signal (3), said LED (5) being fed with a supply current (Iled),
- a photo receiver element (7) designed to collect the luminous signal (3) issued from the emission LED (5) and to generate an electric output signal (Vout) proportionate to the luminous signal (3),
- amplifying means (9) for amplifying the electric output signal (Vout),
- a processing unit (10) for determining the optimum current (Iled),
- a temperature sensor (11) connected to the processing unit (10),
characterised in that the processing unit (10) for determining the optimum current (Iled) is adapted to carry out an initial acquisition step and a thermal compensation step as claimed in claim 8.

## Patentansprüche

1. Verfahren für die Kennzeichnung mehrerer Photozellen mittels einer Vorrichtung, die einen Klimaraum (13) umfaßt, wobei die mehreren Photozellen Emissions-LEDs (5), die ein Lichtsignal (3) aussenden, und Photoempfängerelemente (7) umfassen, wobei wenigstens die LEDs (5) oder die Photoempfängerelemente (7) zu der selben technischen Familie gehören und wenigstens ein Element unter den Emissions-LEDs (5) und den Photoempfängerelementen (7) einer Photozelle der mehreren Photozellen in dem Klimaraum (13) angeordnet wird; mit folgenden Verfahrensschritten:
Versorgen der Emissions-LED (5) der Photozelle mit einem Versorgungsstrom mit einem vorgegebenen Wert (Iled),
Einstellen der Temperatur des Klimaraums (13) auf eine Prüftemperatur mit einem vorgegebenen Wert (T),
Erfassen des Lichtsignals (3), welches von der Emissions-LED (5) an das Photoempfängerelement (7) der Photozelle abgegeben wird, und Erzeugen eines elektrischen Ausgangssignals abhängig von dem erfaßten Lichtsignal (3),
Messen des Wertes des elektrischen Ausgangssignals (Vout),
Speichern des Satzes der drei Werte (Iled, T, Vout),
Wiederholen der vorhergehenden Schritte i-mal, wobei i eine vorgegebene Zahl ist, wobei jedes mal die Werte von zwei der drei Variablen Versorgungsstrom, elektrisches Ausgangssignal und Testtemperatur variiert wird, um mehrere Sätze der drei Werte (Iled, T, Vout) zu speichern und dadurch eine Beziehung zwischen dem Versorgungsstrom, dem elektrischen Ausgangssignal und der Temperatur zum Kennzeichen der Photozelle zu erhalten,
Verwendung der gespeicherten Sätze der drei Werte (Iled, T, Vout) zum Kennzeichen aller anderen Photozellen der mehreren Photozellen.

2. Verfahren nach Anspruch 1, mit folgenden Verfahrensschritten:
a) Auswerten eines Wertes (Voutⱼ) des elektrischen Ausgangssignals,
b) Einstellen der Temperatur des Klimaraums (13) auf eine Testtemperatur (Tᵢ),
c) Versorgen der Emissions-LED (5) mit einem Anfangsversorgungsstrom (Iledᵢⱼ), so daß der Wert des elektrischen Ausgangssignals gleich dem ausgewählten Wert (Voutⱼ) des elektrischen Ausgangssignals ist,
d) Speichern des Satzes der zwei Werte der Temperatur (Tᵢ) und des Anfangsversorgungsstroms (Iledᵢⱼ),
e) Iteratives Wiederholen der Schritte von b) bis d) i-mal, wobei i eine vorgegebene Zahl ist, für verschiedene Werte der Temperatur (Tᵢ) und des Versorgungsstroms (Iledᵢⱼ) zum Aufbauen einer Kennkurve in bezug auf den Wert (Voutⱼ) des elektrischen Ausgangssignals,
f) Iteratives Wiederholen der vorhergehende Schritte j-mal, wobei j eine vorgegebene Zahl ist, und für j unterschiedliche Werte des elektrischen Ausgangssignals (Vout), um j Kennkurven in bezug auf die j Werte des elektischen Ausgangssignals (Vout) aufzubauen.

3. Verfahren nach Anspruch 1, mit folgenden Verfahrensschritten:
a) Versorgen der Emissions-LED (5) mit einem Anfangsversorgungsstrom (Iledⱼ),
b) Einstellen der Temperatur des Klimaraums (13) auf eine Testtemperatur (Tᵢ),
c) Messen des Wertes (Voutᵢⱼ) des elektrischen Ausgangssignals,
d) Speichern des Satzes der zwei Werte der Testtemperatur (Tᵢ) und des elektrischen Ausgangssignals (Voutᵢⱼ),
e) Iteratives Wiederholen der Schritte von b) bis d) i-mal, wobei i eine Zahl vorgegebene Zahl ist, für verschiedene Werte (Tᵢ) der Temperatur, um eine Kennkurve in bezug auf den Wert (Iledⱼ) des Versorgungsstroms aufzubauen,
f) Iteratives Wiederholen der vorhergehenden Schritte j-mal, wobei j eine vorgegebene Zahl ist, und für j verschiedene Werte des Versorgungsstroms (Iled), um j Kennkurven in bezug auf die j Werte des Versorgungsstroms (Iled) aufzubauen.

4. Verfahren nach Anspruch 1, mit folgenden Verfahrensschritten
a) Einstellen der Temperatur des Klimaraums (13) auf eine Testtemperatur (Tⱼ),
b) Versorgen der Emsions-LED (5) mit einem Anfangsversorgungsstrom (Iledᵢ),
c) Messen des Wertes (Voutᵢⱼ) des elektrischen Ausgangssignals,
d) Speichern des Satzes der zwei Werte des Versorgungsstroms (Iledᵢ) und des elektrischen Ausgangssignals (Voutᵢⱼ),
e) Iteratives Wiederholen der Schritte b) bis d) i-mal, wobei i eine vorgegebene Zahl ist, für verschiedene Werte des Versorgungsstroms (Iledᵢ), um eine Kennkurve in bezug auf den Wert (Tⱼ) der Temperatur aufzubauen,
f) Iteratives Wiederholen der vorhergehenden: Schritte j-mal, wobei j eine vorgegebene Zahl ist, für j unterschiedliche Werte der Temperatur (T), um j Kennkurven in bezug auf die j Werte der Temperatur aufzubauen.

5. Verfahren nach Anspruch 1, 2, 3 oder 4, wobei das Photoempfängerelement (7) außerhalb des Klimaraums (13) angeordnet ist und das Lichtsignal (3) von dem Element (7) über eine Lichtleitfaser (15) erfaßt wird, die zwischen der Emissions-LED (5) und dem Photoempfängerelement (7) angeordnet ist.

6. Verfahren nach Anspruch 1, 2, 3, oder 4, wobei die Emissions-LED (5) außerhalb des Klimaraums (13) angeordnet ist und das Lichtsignal (3) zu dem Photoempfängerelement (7) über eine Lichtleitfaser (15) übertragen wird, welche zwischen der Emissions-LED (5) und dem Photoempfängerelement (7) angeordnet ist.

7. Verfahren nach Anspruch 1, 2, 3, oder 4, wobei die Emissioas-LED (5) und das Photoempfängerelement (7) beide in dem Klimaraum (13) angeordnet sind.

8. Verfahren für die automatische Steuerung einer Photozelle, wobei die Photozelle folgende Merkmale aufweist:
eine Emissions-LED (5), welche ein Lichtsignal (3) abgibt, wobei die LED (5) mit einem Versorgungsstrom (Iled) versorgt wird,
ein Photoempfängerelement (7), das so gestaltet ist, daß es das Lichtsignal (3), welches von der Emissions-LED (5) ausgegeben wird, erfaßt und ein elektrisches Ausgangssignal (Vout) abhängig von dem erfaßten Lichtsignal (3) erzeugt, wobei
von der Photozelle eine Beziehung zwischen dem Versorgungsstrom (Iled), dem elektrischen Ausgangssignal (Vout) und der Umgebungstemperatur (T) bekannt ist,
mit folgenden Verfahrensschritten:
a) Aktivieren eines Anfangserfassungsprozesses, um die Photozelle auf einen optimalen Wert des elektrischen Ausgangssignal (Vout) zu steuern, der als Funktion der spezifischen Anwendung der Photozelle gewählt wird,
b) Ausführen eines Temperaturausgleichs der Photozelle gestützt auf die Beziehung zwischen dem Versorgungsstrom (Iled), dem elektrischen Ausgangssignal (Vout) und der Temperatur (T) durch Variieren des Versorgungsstroms (Iled) abhängig von der Änderung der Temperatur (T), bei der die Photozelle arbeitet, um während des Betriebs einen Wert des elektischen Ausgangssignals (Vout) aufrechtzuerhalten, der im wesentlichen gleich dem in dem Anfangserfassungsprozess gewählten optimalen Wert ist,
dadurch **gekennzeichnet,** daß der Anfangserfassungsprozess folgende Schritte umfaßt:
a1) Wählen eines optimalen Wertes des elektrischen Ausgangssignals (Vout) gestützt auf die spezifische Anwendung der Photozelle,
a2) Messen des Temperaturwerts (T), bei der die Photozelle arbeitet,
a3) Speichern des Salzes der zwei Werte des elektrischen Ausgangssignals (Vout) und der Temperatur (T) und Identifizieren eines optimalen Versorgungsstroms (Iled) auf der Grundlage der zuvor gespeicherten Sätze der drei Kennwerte (Iled, T, Vout) des Versorgungsstroms, des elektrischen Ausgangssignals und der Umgebungstemperatur derart, daß der Wert des elektrischen Ausgangssignals (Vout) im wesentlichen gleich dem in dem Anfangserfassungsprozess gewählten optimalen Wert ist.

9. Verfahren nach Anspruch 8, wobei das Identifizieren des optimalen Versorgungsstroms (Iled) im Schritt a3) ausgeführt wird, indem in einem Graphen, der sich auf die Temperatur (T) und den Versorgungsstrom (Iled) bezieht, eine Kennkurve der Photozelle derart identifiziert wird, daß der Wert des elektrischen Ausgangssignals (Vout) im wesentlichen gleich dem optimalen Wert ist, der in dem Anfangserfassungsprozess gewählt wurde.

10. Verfahren nach Anspruch 9, wobei der Schritt des thermischen Ausgleichens der Photozelle die folgenden Schritte umfaßt:
b1) Erfassen einer Änderung der Temperatur, bei der die Photozelle arbeitet,
b2) Verändern des Versorgungsstoms (Iled) nach Maßgabe der Kennkurve, die im Schritt a3) identifiziert wurde, so daß das elektrische Ausgangssignal (Vout) im wesentlichen auf dem optimalen Wert gehalten wird, der in dem Anfangserfassungsprozeß gewählt wurde.

11. Photozelle mit folgenden Merkmalen:
eine Emissions-LED (5), welche ein Lichtsignal (3) abgibt, wobei die LED (5) mit einem Versorgungsstrom (Iled) versorgt wird,
ein Photoempfängerelement (7), welches das Lichtsignal (3), das von der Emissions-LED (5) abgegeben wird, erfassen kann und ein elektrisches Ausgangssignal (Vout) im Verhältnis zu dem Lichtsignal (3) erzeugen kann,
eine Verstärkervorrichtung (9) zum Verstärken des elektrischen Ausgangssignals (Vout),
eine Verarbeitungseinheit (10) zum Bestimmen des optimalen Stroms (Iled),
ein Temperatursensor (11), der mit der Verarbeitungseinheit (10) verbunden ist, dadurch **gekennzeichnet,** daß die Verarbeitungseinheit zum Bestimmen des optimalen Stroms (Iled) dazu geeignet ist, einen Anfangserfassungsschritt und einen thermischen Ausgleich gemäß Anspruch 8 durchzuführen.

## Revendications

1. Procédé pour caractériser plusieurs cellules photoélectriques au moyen d'un appareillage comprenant une salle climatique (13), lesdites plusieurs cellules photoélectriques comprenant des DEL émettrices (5) émettant un signal lumineux (3) et des éléments photorécepteurs (7), au moins les DEL (5) ou les éléments photorécepteurs (7) appartenant à la même famille technologique et au moins un élément parmi la LED émettrice (5) et l'élément photorécepteur (7) d'une cellule photoélectrique desdites plusieurs cellules photoélectriques est placé dans la salle climatique (13), le procédé comprenant les étapes suivantes :
- alimenter la DEL émettrice (5) de ladite cellule photoélectrique avec un courant d'alimentation (Iled) ayant une valeur prédéterminée,
- réguler la température de la salle climatique (13) à une température d'essai (T) ayant une valeur prédéterminée,
- collecter dans l'élément photorécepteur (7) de ladite cellule photoélectrique le signal lumineux (3) issu de la DEL émettrice (5) et générer un signal de sortie électrique en réponse au signal lumineux collecté (3),
- mesurer la valeur du signal de sortie électrique (Vout),
- enregistrer le groupe des trois valeurs (Iled, T, Vout),
- répéter les étapes précédentes pour un nombre prédéterminé i de fois, en faisant varier chaque fois les valeurs de deux des trois variables courant d'alimentation, signal de sortie électrique et température d'essai, de façon à enregistrer un certain nombre de groupes de trois valeurs (Iled, T, Vout), de façon à obtenir une relation entre le courant d'alimentation, le signal de sortie électrique et la température pour caractériser ladite cellule photoélectrique,
- utiliser lesdits groupes enregistrés de trois valeurs (Iled, T, Vout) pour caractériser toutes les autres cellules photoélectriques desdites plusieurs cellules photoélectriques.

2. Procédé selon la revendication 1, comprenant les étapes suivantes :
a) choisir une valeur (Voutⱼ) du signal de sortie électrique,
b) réguler la température de la salle climatique (13) à une température d'essai (Tᵢ),
c) alimenter la LED émettrice (5) avec un courant d'alimentation initial (Iledᵢⱼ), de façon que la valeur du signal de sortie électrique soit égale à la valeur choisie (Voutⱼ) du signal de sortie électrique,
d) enregistrer le groupe des deux valeurs de la température (Tᵢ) et du courant d'alimentation initiale (Iledᵢⱼ),
e) répéter itérativement, un nombre prédéterminé i de fois, les étapes de b) à d) pour différentes valeurs de la température (Tᵢ) et du courant d'alimentation (Iledᵢⱼ) de façon à construire une courbe de caractérisation relativement à la valeur (Voutⱼ) du signal de sortie électrique,
f) répéter itérativement les étapes précédentes un nombre prédéterminé j de fois et pour j valeurs différentes du signal de sortie électrique (Vout), de façon à construire j courbes de caractérisation relatives aux j valeurs du signal de sortie électrique (Vout).

3. Procédé selon la revendication 1, comprenant les étapes suivantes :
a) alimenter la LED émettrice (5) avec un courant d'alimentation initial (Iledⱼ),
b) réguler la température de la salle climatique (13) à une température d'essai (Tᵢ),
c) mesurer la valeur (Voutᵢⱼ) du signal de sortie électrique,
d) enregistrer le groupe de deux valeurs de la température d'essai (Tᵢ) et du signal de sortie électrique (Voutᵢⱼ),
e) répéter itérativement, un nombre prédéterminé i de fois, les étapes de b) à d) pour différentes valeurs (Tᵢ) de la température et de façon à construire une courbe de caractérisation relativement à la valeur (Iledⱼ) du courant d'alimentation,
f) répéter itérativement les étapes précédentes un nombre prédéterminé j de fois et pour j valeurs différentes du signal du courant d'alimentation (Iled), de façon à construire j courbes de caractérisation relatives aux j valeurs du courant d'alimentation (Iled).

4. Procédé selon la revendication 1, comprenant les étapes suivantes :
a) réguler la température de la salle climatique (13) à une température d'essai (Tj),
b) alimenter la LED émettrice (5) avec un courant d'alimentation initial (Iledᵢ),
c) mesurer la valeur (Voutᵢⱼ) du signal de sortie électrique,
d) enregistrer le groupe de deux valeurs du courant d'alimentation (Iledᵢ) et du signal de sortie électrique (Voutᵢⱼ),
e) répéter itérativement, un nombre prédéterminé i de fois, les étapes de b) à d) pour différentes valeurs du courant d'alimentation (Iledᵢ) de façon à construire une courbe de caractérisation relativement à la valeur (Tⱼ) de la température,
f) répéter itérativement les étapes précédentes un nombre prédéterminé j de fois et pour j valeurs différentes de la température (T), de façon à construire j courbes de caractérisation relatives aux j valeurs de la température.

5. Procédé selon les revendications 1, 2, 3 ou 4, dans lequel l'élément photorécepteur (7) est positionné hors de la salle climatique (13) et le signal lumineux (3) est collecté par cet élément (7) à travers une fibre optique (15) placée entre la LED émettrice (5) et l'élément photorécepteur (7).

6. Procédé selon les revendications 1, 2, 3 ou 4, dans lequel la LED émettrice (5) est positionnée hors de la salle climatique (13) et le signal lumineux (3) est conduit à l'élément photocopieur(7) à travers une fibre optique (15) placée entre la LED émettrice (5) et l'élément photorécepteur (7).

7. Procédé selon les revendications 1, 2, 3, ou 4, dans lequel la LED émettrice (5) et l'élément photorécepteur (7) sont tous deux positionnés dans la salle climatique (13).

8. Procédé pour la commande automatique d'une cellule photoélectrique, cette cellule comprenant :
- une LED émettrice (5) émettant un signal lumineux (3), cette LED (5) étant alimentée avec un courant d'alimentation (Iled),
- un élément photorécepteur (7) destiné à collecter le signal lumineux (3) issu de la LED émettrice (5) et à générer un signal de sortie électrique (Vout) en réponse au signal lumineux collecté (3),
cellule photoélectrique dont on connaît une relation entre le courant d'alimentation (Iled), le signal de sortie électrique (Vout) et la température environnante (T),
le procédé comprenant les étapes de fonctionnement suivantes :
a) activer un procédé d'acquisition initiale de façon à commander la cellule photoélectrique à une valeur optimale du signal de sortie électrique (Vout) choisie en fonction de l'application spécifique de la cellule photoélectrique,
b) effectuer une compensation thermique de la cellule photoélectrique en se basant sur la relation entre le courant d'alimentation (Iled), le signal de sortie électrique (Vout), et la température (T), en faisant varier le courant d'alimentation (Iled) en fonction des variations de la température (T) à laquelle fonctionne la cellule photoélectrique, de façon à maintenir pendant le fonctionnement une valeur du signal de sortie électrique (Vout) sensiblement égale à la valeur optimum choisie dans le procédé d'acquisition initiale,
caractérisé en ce que le procédé d'acquisition initiale comprend les étapes suivantes :
a1) choisir sur la base de l'application spécifique de la cellule photoélectrique une valeur optimum du signal de sortie électrique (Vout),
a2) mesurer la valeur de température (T) à laquelle la cellule photoélectrique fonctionne,
a3) enregistrer ledit groupe des deux valeurs du signal de sortie électrique (Vout) et de la température (T) et identifier parmi des groupes préalablement enregistrés de trois valeurs de caractérisation (Iled, T, Vout) du courant d'alimentation, du signal de sortie électrique et de la température environnante, un courant d'alimentation optimum (Iled) tel que la valeur du signal de sortie électrique (Vout) soit sensiblement égale à la valeur optimum choisie dans le procédé d'acquisition initiale.

9. Procédé selon la revendication 8, dans lequel l'identification du courant d'alimentation optimum (Iled) de l'étape a3) est effectuée en identifiant dans un graphe faisant correspondre la température (T) et le courant d'alimentation (Iled) une courbe de caractérisation de la cellule photoélectrique telle que la valeur du signal de sortie électrique (Vout) soit sensiblement égale à la valeur optimum choisie dans le procédé d'acquisition initiale.

10. Procédé selon revendication 9, dans lequel l'étape de compensation thermique de la cellule photoélectrique comprend les étapes suivantes :
b1) détecter une variation de la température à laquelle la cellule photoélectrique fonctionne,
b2) faire varier le courant d'alimentation (Iled) en fonction de la courbe de caractérisation identifiée dans l'étape a3) de façon que le signal de sortie électrique (Vout) soit maintenu sensiblement égal à la valeur choisie optimum dans le procédé
d'acquisition initiale.

11. Cellule photoélectrique comprenant :
- une LED émettrice (5) émettant un signal lumineux (3), ladite LED (5) étant alimentée avec un courant d'alimentation (Iled),
- un élément photorécepteur (7) destiné à collecter le signal lumineux (3) issu de la LED émettrice (5) et à générer un signal de sortie électrique (Vout) proportionné au signal lumineux (3),
- des moyens amplificateurs (9) pour amplifier le signal de sortie électrique (Vout),
- une unité de traitement (1) pour déterminer le courant optimum (Iled),
- un capteur de température (11) relié à l'unité de traitement (10),
caractérisée en ce que l'unité de traitement (10) pour déterminer le courant optimum (Iled) est adapté à effectuer une étape d'acquisition initiale et une étape de compensation thermique selon la revendication 8.
